# EUROPÄISCHE PATENTSCHRIFT

(11) **EP 0 733 665 B1**
(45) Veröffentlichungstag und Bekanntmachung des Hinweises auf die Patenterteilung: **29.07.1998**
(21) Anmeldenummer: 96103809.8
(22) Anmeldetag: 11.03.1996
(51) Int. Cl.: C08G 69/28, C08G 69/32, G03F 7/023, C08G 73/22

(54) **Verfahren zur Herstellung von Polybenzoxazol-Vorstufen und entsprechender Resistlösungen**
Process for the preparation of polybenzoxazol precursors and their corresponding resist solutions
Procédé de préparation des progéniteurs de polybenzoxazole et des solutions de réserve correspondantes

(30) Priorität: 23.03.1995 DE 19510536; 23.03.1995 DE 19510538
(43) Veröffentlichungstag der Anmeldung: 25.09.1996
(73) Patentinhaber: SIEMENS AKTIENGESELLSCHAFT, 80333 München (DE)
(72) Erfinder: Sezi, Recai, Dr., 91341 Röttenbach (DE); Rissel, Eva, 91301 Forchheim (DE); Ahne, Hellmut, Dr., 91341 Röttenbach (DE)

(56) Entgegenhaltungen:
- EP-A- 0 264 678
- EP-A- 0 291 779

## Beschreibung

Die Erfindung betrifft ein Verfahren zur Herstellung von Lösungen alkalilöslicher Polybenzoxazol-Vorstufen sowie von Resistlösungen auf der Basis derartiger Vorstufen.

In der Mikroelektronik werden, insbesondere als Isolierschichten und Dielektrika, hochwärmebeständige Polymere benötigt. Vorstufen von derartigen Polymeren, wie Polyimide (PI) und Polybenzoxazole (PBO), können durch geeignete Zusätze oder durch eine Modifizierung photoreaktiv eingestellt und photochemisch direkt strukturiert werden. Die Vorstufen, im folgenden auch als Prepolymere bezeichnet, werden durch eine Temperaturbehandlung in das entsprechende Polymer (PI bzw. PBO) umgewandelt; dabei ergeben sich die endgültigen Eigenschaften. Derartige Polymere können mittels eines Resists auch indirekt strukturiert werden.

In der Mikroelektronik werden außerdem hochwärmebeständige Photoresists benötigt, insbesondere für die direkte Erzeugung von strukturierten Isolierschichten und von Dielektrika. Derartige Photoresists enthalten im allgemeinen ein Basisharz und eine photoaktive Komponente (PAC). Als photoaktive Komponenten werden meistens Diazoketone eingesetzt, insbesondere Chinondiazide. Als Basisharz dienen insbesondere Vorstufen von Polyimiden und Polybenzoxazolen, welche nach der Photostrukturierung durch eine Temperaturbehandlung in das entsprechende Polymer (PI bzw. PBO) umgewandelt werden. Die erzeugten Strukturen dürfen sich bei den Temperaturen, die bei der weiteren Verarbeitung bzw. während der Lebensdauer des jeweiligen elektronischen Bauteils auftreten, weder deformieren noch zersetzen.

Photosensitive PBO-Vorstufen bieten, im Gegensatz zu den meisten PI-Vorstufen, den Vorteil einer Strukturierbarkeit im positiven Modus und die Möglichkeit einer Entwicklung mit einem wäßrig-alkalischen Medium (siehe dazu EP-PS 0 023 662 und EP-OS 0 264 678). Ein wesentlicher Vorteil der positiven Strukturierbarkeit ist die geringere Defektdichte bei der Strukturierung der sogenannten "via-holes", weil - im Vergleich zu negativ arbeitenden Systemen - nur ein Bruchteil der Fläche belichtet wird.

Die für eine direkte Strukturierung geeigneten PBO-Prepolymere müssen außer einer angepaßten Alkalilöslichkeit auch eine gute Löslichkeit in organischen Lösemitteln aufweisen, damit sie aus einer Lösung - mittels Schleuder- oder Sprühtechniken - in der gewünschten Konzentration auf ein Substrat aufgebracht werden können.

Die gängigste Methode zur Herstellung von alkalilöslichen PBO-Prepolymeren, beispielsweise als Basisharz für hochwärmebeständige Photoresists, ist die Umsetzung eines Dicarbonsäurechlorids mit einem geeigneten Bis-(o-aminophenol). Zum Abfangen des bei der Reaktion entstehenden Chlorwasserstoffs (HCl) wird in der Regel eine lösliche Base, wie Pyridin oder Triethylamin, zugesetzt (siehe EP-OS 0 264 678 und EP-PS 0 291 779). Gegebenenfalls müssen das in der PBO-Vorstufe verbleibende restliche Chlorid sowie andere Ionen mittels Ionenaustauscher entfernt werden, weil sie auf Dauer die Funktion der mikroelektronischen Bauteile beeinträchtigen können.

Nach beendeter Reaktion muß die PBO-Vorstufe - zur Reinigung - in einem geeigneten Fällungsmittel ausgefällt und dann gewaschen und getrocknet werden. Um eine gebrauchsfertige Prepolymerlösung zu erhalten, wird die PBO-Vorstufe anschließend, gegebenenfalls zusammen mit Additiven, in einem geeigneten Lösemittel gelöst und dann druckfiltriert. In entsprechender Weise wird zur Herstellung gebrauchsfertiger Resistlösungen vorgegangen, wobei die PBO-Vorstufe zusammen mit der photoaktiven Komponente gelöst wird. Zur Druckfiltration werden meistens Membranfilter mit einer Porengröße von ca. 0,2 bis 1 µm verwendet. Die Druckfiltration (Feinfiltration) ist für Anwendungen in der Mikroelektronik unerläßlich, weil sonst Fremdpartikel, wie Staub, in der Lösung bzw. - nach dem Schleudern - im gebildeten Prepolymer- bzw. Resistfilm verbleiben und dabei Defektstellen erzeugen. Solche Defektstellen beeinträchtigen die eigentliche Funktion dieser Schicht in starkem Maße. Deshalb werden beispielsweise sämtliche kommerziell erhältlichen (photosensitiven) Dielektrika bzw. Resists auf Polyimidbasis in filtrierter Form angeboten.

Die Feinfiltration der Prepolymer- bzw. Resistlösung kann Probleme bereiten, wenn die zu filtrierende Lösung Teilchen bzw. Moleküle der PBO-Vorstufe enthält, die nur sehr schwer oder überhaupt nicht durch die Poren des Feinfilters gehen. Die Entstehung derartiger Teilchen wird vor allem durch das Syntheseverfahren der PBO-Vorstufe bestimmt. Die Filtrierbarkeit der Resistlösung kann außerdem durch eine Wechselwirkung zwischen der photoaktiven Komponente und dem Basisharz beeinflußt werden.

PBO-Prepolymere werden, wie bereits erwähnt, durch Umsetzung eines Dicarbonsäurechlorids mit einem Bis-(o-aminophenol) hergestellt. Säurechloride reagieren aber nicht nur mit Aminogruppen (unter Amidbildung), sondern auch mit Hydroxylgruppen (unter Esterbildung). Da Bis-(o-aminophenole) sowohl zwei Amino- als auch zwei Hydroxyfunktionen aufweisen, können neben den Aminogruppen auch die Hydroxylgruppen mit dem Säurechlorid reagieren. Dies führt aber zu einer Teilvernetzung bzw. Gelbildung und demzufolge zu einer schlechten Filtrierbarkeit der Lösung. Die Bildung von sehr kleinen Gelpartikeln wird aber insbesondere erst bei der Feinfiltration der gebrauchsfertigen Lösung mit Filtern einer Porengröße ≤ 1 µm festgestellt. Seltener zeigt sich die schwierige Filtrierbarkeit bereits beim Filtrieren der ausgefällten PBO-Vorstufe direkt nach der Kondensationsreaktion, weil die dabei verwendeten Filter, wie Faltenfilter, in der Regel eine wesentlich größere Porenweite besitzen.

Enthält die Prepolymer- bzw. Resistlösung eine bestimmte Menge solcher gelartiger Teilchen, so kann die Feinfiltration ein Mehrfaches des normalen Arbeitsaufwandes erfordern, insbesondere einen mehrmaligen Filterwechsel. Noch dazu ist jeder Filterwechsel mit einem Substanzverlust verbunden. Da beim Herstellungsprozeß gewisse Schwankungen nicht vollkommen ausgeschlossen werden können, kommt es auch öfters vor, daß einzelne Chargen kaum noch filtrierbar sind und deshalb nicht verwendet werden können. Bei den hohen Materialkosten ist dies ebenfalls ein großer Nachteil.

Für eine kostengünstige Herstellung sind ferner kostenintensive Arbeitsschritte, wie Ausfällen, Waschen und Trocknen der PBO-Vorstufe, möglichst zu vermeiden. So wird zum Ausfällen in der Regel die 6- bis 10fache Menge an Fällungsmittel, bezogen auf das Volumen der Reaktionslösung, benötigt. Die Entsorgung des verunreinigten Fällungsmittels ist aber nicht nur von der Kostenseite her, sondern auch aus Gründen des Umweltschutzes nachteilig. Entsprechendes gilt für die Trocknung der Polymer-Vorstufen.

Bei gebrauchsfertigen Resistlösungen ist es ferner wichtig, daß die bei der Synthese der Prepolymeren eingesetzte Base, wie Pyridin und Triethylamin, auch nicht in geringsten Mengen vorhanden ist. In der Lösung verbleibende Basenreste zerstören nämlich während der Lagerung die bevorzugt verwendeten photoaktiven Komponenten auf der Basis von Chinondiaziden.

Neben den genannten Verwendungszwecken können PBO-Polymere in der Mikroelektronik auch als Abdeckschichten eingesetzt werden. Die Anwendung dieser Polymere ist aber nicht auf die Mikroelektronik beschränkt. Auch in der Membrantechnik können PBO-Polymere zum Einsatz gelangen, beispielsweise bei der Trennung von Gasen. Für die Herstellung defektfreier Membranen kann aber eine gute Filtrierbarkeit der dabei verwendeten Lösungen bzw. eine Feinfiltration ebenfalls Voraussetzung sein.

Aufgabe der Erfindung ist es, ein kostengünstiges Verfahren zur Herstellung von Lösungen gut löslicher Polybenzoxazol-Vorstufen bzw. von Resistlösungen auf der Basis von derartigen Vorstufen und photoaktiven Komponenten anzugeben, die eine problemlose Feinfiltration ermöglichen; das Verfahren soll außerdem eine umweltfreundliche Herstellung der Vorstufen ermöglichen, d.h. es sollen Abfälle vermieden und damit auch Entsorgungskosten eingespart werden.

Dies wird erfindungsgemäß dadurch erreicht, daß - zur Herstellung der Vorstufen - ein Dicarbonsäurehalogenid mit einem Bis-(o-aminophenol) in einem organischen Lösemittel in Gegenwart eines im Lösemittel unlöslichen Polymers mit einem tertiären N-Atom zur Reaktion gebracht wird, und daß überschüssiges Polymer und dessen Hydrohalogenid von der Reaktionslösung abgetrennt wird. Zur Herstellung von Resistlösungen wird die Reaktionslösung dann noch mit einer photoaktiven Komponente versetzt.

Beim Verfahren nach der Erfindung wird die bei der Umsetzung zwischen dem Dicarbonsäurehalogenid und dem Bis(o-aminophenol) entstehende Säure, wie Chlorwasserstoff, nicht mit einer löslichen Base, wie Pyridin und Triethylamin, sondern mit einem im Reaktionsmedium, d.h. dem Lösemittel, vollständig unlöslichen, festen Polymer, das ein tertiäres Stickstoffatom aufweist, abgefangen und gebunden, beispielsweise als Hydrochlorid. Auf derartige Weise hergestellte Prepolymerlösungen bzw. Resistlösungen, die auch eine photoaktive Komponente enthalten, können überraschenderweise ohne Probleme filtriert werden.

Das Polymer ist vorzugsweise ein Vinylpyridin-Polymer, insbesondere vernetztes Poly(4-vinylpyridin). Daneben kommen als Säurefänger auch folgende Verbindungen in Betracht: Polymere von Acryl-, Methacryl-, Allyl- und Vinylverbindungen mit einem tertiären Stickstoffatom, wobei bei Co- und Terpolymeren mindestens eines der Monomere ein N-Atom hat.

Als Lösemittel, Dicarbonsäurehalogenid und Bis-(o-aminophenol) werden im allgemeinen übliche Verbindungen eingesetzt, wobei N-Methylpyrrolidon (als Lösemittel) bevorzugt wird. Als Dicarbonsäurederivat dient vorzugsweise ein Dicarbonsäurechlorid, als Bis-(o-aminophenol) ein 2,2-Bis-(3-amino-4-hydroxyphenyl)-propan. Die photoaktive Komponente ist im allgemeinen ebenfalls eine übliche Verbindung, wobei Chinondiazide bevorzugt werden.

Beim Verfahren nach der Erfindung wird - nach der Synthese des Prepolymers - das Hydrohalogenid des eingesetzten Polymers sowie gegebenenfalls überschüssiges Polymer entfernt, im allgemeinen durch Filtration, beispielsweise unter Verwendung eines Faltenfilters. Die dabei erhaltene Reaktionslösung kann, bevor sie weiterverarbeitet bzw. mit der photoaktiven Komponente versetzt wird, über einen Ionenaustauscher gereinigt werden. Vor dem Einsatz bzw. nach dem Zusatz der photoaktiven Komponente wird die Lösung durch ein Membranfilter, im allgemeinen mit einer Porenweite von 0,2 bis 0,5 µm, filtriert, was problemlos möglich ist; sie ist dann gebrauchsfertig.

Die gebrauchsfertige Lösung kann auch in der Weise hergestellt werden, daß das Prepolymer aus der Reaktionslösung ausgefällt, getrocknet und - gegebenenfalls zusammen mit der photoaktiven Komponente - wieder in einem geeigneten Lösemittel gelöst wird. Auch die Feinfiltration einer derartigen Lösung verläuft schnell und problemlos. Im übrigen können die Lösungen der Polymer-Vorstufen bzw. die Resistlösungen auch aufkonzentriert werden.

Die filtrierte Prepolymer- bzw. Resistlösung kann direkt auf die zu isolierende bzw. schützende Unterlage aufgebracht werden, beispielsweise durch Aufschleudern. Nach dem Trocknen, beispielsweise auf einer Heizplatte bei 100 bis 130°C, erhält - im Falle einer Prepolymerlösung - der entstandene gleichmäßige Film durch Temperung bei 300 bis 450°C, wobei das Prepolymer in Polybenzoxazol übergeführt wird, die endgültigen Eigenschaften. Wird der Film nicht getempert, sondern nur getrocknet, so ist er in metallionenfreien wäßrig-alkalischen Entwicklern löslich und erfüllt damit eine wichtige Voraussetzung für die Verwendbarkeit als Basisharz für positiv arbeitende photostrukturierbare Isolierschichten. Im Falle einer Resistlösung wird nach dem Trocknen, beispielsweise auf einer Heizplatte bei 100 bis 130°C, der entstandene gleichmäßige Resistfilm photolithographisch strukturiert. Durch Temperung bei 300 bis 450°C, wobei das Prepolymer in Polybenzoxazol übergeführt wird, erhält der strukturierte Film die endgültigen Eigenschaften.

Das Verfahren nach der Erfindung eignet sich insbesondere zur Herstellung von Prepolymer- bzw. Resistlösungen, die in der Mikroelektronik zur Erzeugung von gegebenenfalls photosensitiven Isolierschichten und Dielektrika benötigt werden. Ein besonders wirtschaftlicher und umweltrelevanter Vorteil ist dabei, daß teure Arbeitsschritte, wie Ausfällen und Trocknen des PBO-Prepolymers sowie Entsorgen eines Fällungsmittels, eingespart werden können.

Anhand folgender Beispiele wird die Erfindung noch näher erläutert.

### Beispiel 1: Herstellung einer Prepolymerlösung und einer Resistlösung

21 g trockenes vernetztes Poly(4-vinylpyridin) und 21,96 g 1,1,1,3,3,3-Hexafluor-2,2-bis-(3-amino-4-hydroxyphenyl)-propan (0,06 mol) werden unter Stickstoff in ein trockenes Reaktionsgefäß gegeben. Durch Zugabe von 198 g trockenem N-Methylpyrrolidon (NMP) wird das Bisaminophenol gelöst (unter Rühren), anschließend wird das Reaktionsgefäß so lange gekühlt, bis die Temperatur der Lösung -10°C erreicht hat. Danach werden 14,75 g Diphenylether-4,4'-dicarbonsäuredichlorid (0,05 mol), gelöst in 133 g trockenem N-Methylpyrrolidon langsam zur Bisaminophenollösung getropft. Nach beendeter Zugabe wird eine weitere Stunde bei -10°C gerührt, dann wird die Kühlung entfernt und die Reaktionslösung etwa 18 bis 20 h gerührt. Anschließend werden 3,28 g Norbornenanhydrid (0,02 mol), gelöst in 30 g trockenem N-Methylpyrrolidon, bei 5°C zugetropft, und dann wird nochmals etwa 18 bis 20 h bei Raumtemperatur gerührt. Die dabei erhaltene Lösung des PBO-Prepolymers wird zur Abtrennung des Poly(4-vinylpyridins) bzw. des Hydrochlorids über ein Faltenfilter filtriert.

In 22 g der Reaktionslösung werden 0,5 g eines Diesters aus Bisphenol A und Naphthochinondiazid-4-sulfonsäure als photoaktive Komponente vollständig gelöst. Diese Resistlösung wird in einer braunen Flasche aufbewahrt.

### Beispiel 2: Filmbildung

18 ml der Prepolymerlösung oder der Resistlösung nach Beispiel 1 werden in eine 20 ml-Spritze eingezogen, die dann mit einem Filter (0,2 µm) versehen wird. 2 ml der jeweiligen Lösung werden durch das Filter auf einen gereinigten und getrockneten Siliciumwafer aufgebracht; die Filtration verläuft einfach und problemlos. Durch Schleudern wird der Wafer gleichmäßig mit der Lösung beschichtet. Nach dem Trocknen auf einer Heizplatte bei 120°C wird der gebildete Film in einem Temperofen bei 350°C unter Stickstoff getempert. Es wird eine gleichmäßige hochwärmebeständige Schutzschicht erhalten.

### Beispiel 3: Löslichkeit in alkalischen Entwicklern

Weitere 2 ml der Prepolymerlösung werden entsprechend Beispiel 2 durch das Filter auf einen gereinigten Siliciumwafer aufgebracht und auf einer Heizplatte bei 120°C getrocknet. Anschließend wird der gebildete gleichmäßige Film mit einem handelsüblichen wäßrig-alkalischen Entwickler (NSD-TD, Fa. Tokyo Ohka) in Kontakt gebracht. Dabei wird eine kontinuierliche und gleichmäßige Auflösung des Films im Entwickler festgestellt.

### Beispiel 4: Photostrukturierung

Weitere 2 ml der Resistlösung werden entsprechend Beispiel 2 durch das Filter auf einen gereinigten Siliciumwafer aufgebracht und auf einer Heizplatte bei 120°C getrocknet. Anschließend wird der gebildete gleichmäßige Film durch eine Testmaske kontaktbelichtet (Breitbandbelichtung mit dem Gerät MA 56 M, Fa. Karl Süss). Danach werden die belichteten Bereiche mit einem handelsüblichen wäßrig-alkalischen Entwickler (NSD-TD, Fa. Tokyo Ohka) herausgelöst, dann wird mit Wasser gespült und bei 90°C auf einer Heizplatte getrocknet. Es werden positive Strukturen guter Qualität erhalten.

### Beispiel 5: Feinfiltration

Die restliche in der Spritze verbliebene Menge der Prepolymerlösung bzw. der Resistlösung (jeweils 14 ml) wird durch das Filter in ein Gefäß filtriert. Die Filtration erfolgt dabei weiterhin einfach und problemlos.

### Beispiel 6: Herstellung von Lösungen mit ausgefälltem PBO-Prepolymer

Eine Prepolymerlösung oder eine Reaktionslösung nach Beispiel 1 wird mit dem zehnfachen Volumen eines Gemisches aus Isopropanol und Wasser (Fällungsmittel) versetzt, wobei das PBO-Prepolymer ausgefällt wird. Das Prepolymer wird dann über ein Papierfilter abgesaugt, mit weiterem Fällungsmittel viermal gewaschen, in eine Glasschale gebracht und bei 50°C unter Vakuum bis zur Gewichtskonstanz getrocknet.

Im Falle der Prepolymerlösung wird aus dem getrockneten PBO-Prepolymer eine 30 %ige Lösung in N-Methylpyrrolidon hergestellt. Bei Versuchen entsprechend den Beispielen 2, 3 und 5 wird festgestellt, daß die Filmqualität (nach Trocknung und Temperung) sowie die Alkalilöslichkeit einwandfrei sind und die Filtration problemlos verläuft.

Im Falle einer Reaktionslösung wird aus 6 g des getrockneten Prepolymers, 1,5 g der photoaktiven Komponente (siehe Beispiel 1) und 17,5 g trockenem N-Methylpyrrolidon eine Resistlösung hergestellt. Bei Versuchen entsprechend den Beispielen 2, 4 und 5 wird festgestellt, daß die Filmqualität (nach Trocknung und Temperung) sowie die Photostrukturierbarkeit einwandfrei sind und die Filtration problemlos verläuft.

### Beispiel 7: Herstellung einer Prepolymerlösung und einer Resistlösung

17 g trockenes vernetztes Poly(4-vinylpyridin) und 18,3 g 1,1,1,3,3,3-Hexafluor-2,2-bis-(3-amino-4-hydroxyphenyl)-propan (0,05 mol) werden unter Stickstoff in ein trockenes Reaktionsgefäß gegeben. Durch Zugabe von 165 g trockenem N-Methylpyrrolidon (NMP) wird das Bisaminophenol gelöst (unter Rühren), anschließend wird das Reaktionsgefäß so lange gekühlt, bis die Temperatur der Lösung -10°C erreicht hat. Danach werden 11,8 g Diphenylether-4,4'-dicarbonsäuredichlorid (0,04 mol), gelöst in 106 g trockenem N-Methylpyrrolidon, langsam zur Bisaminophenollösung getropft. Nach beendeter Zugabe wird eine weitere Stunde bei -10°C gerührt, dann wird die Kühlung entfernt und die Reaktionslösung etwa 18 bis 20 h gerührt. Anschließend werden 3,28 g Norbornenanhydrid (0,02 mol), gelöst in 30 g trockenem N-Methylpyrrolidon, bei 5°C zugetropft und dann wird nochmals etwa 18 bis 20 h bei Raumtemperatur gerührt. Die dabei erhaltene Lösung des PBO-Prepolymers wird zur Abtrennung des Poly(4-vinylpyridins) bzw. des Hydrochlorids über ein Faltenfilter filtriert. Nachfolgend wird die Reaktionslösung zuerst mit einem handelsüblichen Anionenaustauscher (Ionenaustauscher III, Fa. Merck) und dann mit einem handelsüblichen Kationenaustauscher (Amberlyst 15, Fa. Merck) gereinigt.

Die in der beschriebenen Weise erhaltene Reaktionslösung wird mit dem zehnfachen Volumen eines Gemisches aus Isopropanol und Wasser, (Fällungsmittel) versetzt, wobei das PBO-Prepolymer ausgefällt wird. Das Prepolymer wird dann über ein Papierfilter abgesaugt, mit weiterem Fällungsmittel viermal. gewaschen, in eine Glasschale gebracht und bei 50°C unter Vakuum bis zur Gewichtskonstanz getrocknet.

Aus dem getrockneten PBO-Prepolymer wird eine 30 %ige Lösung in N-Methylpyrrolidon hergestellt. Bei Versuchen entsprechend den Beispielen 2, 3 und 5 wird festgestellt, daß die Filmqualität (nach Trocknung und Temperung) sowie die Alkalilöslichkeit einwandfrei sind und die Filtration problemlos verläuft.

Aus 6 g des getrockneten Prepolymers, 1,5 g der photoaktiven Komponente (siehe Beispiel 1) und 17,5 g trockenem N-Methylpyrrolidon wird eine Resistlösung hergestellt. Bei Versuchen entsprechend den Beispielen 2, 4 und 5 wird festgestellt, daß die Filmqualität (nach Trocknung und Temperung) sowie die Photostrukturierbarkeit einwandfrei sind und die Filtration problemlos verläuft.

### Beispiel 8: Herstellung einer Prepolymerlösung und einer Resistlösung (Vergleichsversuche)

Entsprechend Beispiel 6 wird ein PBO-Prepolymer hergestellt, mit der Ausnahme, daß - anstelle von Poly(4-vinylpyridin) - 12,64 g trockenes Pyridin (0,16 mol) als Säurefänger eingesetzt wird; die Mengenverhältnisse der übrigen Komponenten bleiben unverändert. Zur Abtrennung des Pyridins bzw. Pyridinhydrochlorids wird die erhaltene Lösung des Prepolymers mit dem zehnfachen Volumen eines Gemisches aus Isopropanol und Wasser (Fällungsmittel) versetzt, wobei das PBO-Prepolymer ausgefällt wird. Das Prepolymer wird dann über ein Papierfilter abgesaugt, mit weiterem Fällungsmittel viermal gewaschen, in eine Glasschale gebracht und bei 50°C unter Vakuum bis zur Gewichtskonstanz getrocknet.

Aus dem getrockneten PBO-Prepolymer wird eine 30 %ige Lösung in N-Methylpyrrolidon hergestellt. Bei Versuchen entsprechend den Beispielen 2, 3 und 5 wird festgestellt, daß zwar die Filmqualität (nach Trocknung und Temperung) sowie die Alkalilöslichkeit gut sind, die Filtrierbarkeit jedoch deutlich schlechter ist als bei der Prepolymerlösung nach der Erfindung. Die Filtration wird nämlich bereits nach den ersten 4 bis 5 ml deutlich schwieriger; nach der Filtration von ca. 8 ml der Lösung kann die restliche Menge nicht mehr filtriert werden.

Aus 6 g des getrockneten Prepolymers, 1,5 g der photoaktiven Komponente (siehe Beispiel 1) und 17,5 g trockenem N-Methylpyrrolidon wird eine Resistlösung hergestellt. Bei Versuchen entsprechend den Beispielen 2, 4 und 5 wird festgestellt, daß zwar die Filmqualität (nach Trocknung und Temperung) sowie die Photostrukturierbarkeit gut sind, die Filtrierbarkeit jedoch deutlich schlechter ist als bei der Resistlösung nach der Erfindung. Die Filtration wird nämlich bereits nach den ersten 4 bis 5 ml deutlich schwieriger; nach der Filtration von ca. 9 ml der Lösung kann die restliche Menge nicht mehr filtriert werden.

## Patentansprüche

1. Verfahren zur Herstellung von Lösungen alkalilöslicher Polybenzoxazol-Vorstufen, **dadurch gekennzeichnet**, daß ein Dicarbonsäurehalogenid mit einem Bis-(o-aminophenol) in einem organischen Lösemittel in Gegenwart eines im Lösemittel unlöslichen Polymers mit einem tertiären N-Atom zur Reaktion gebracht wird, und daß überschüssiges Polymer und dessen Hydrohalogenid von der Reaktionslösung abgetrennt wird.

2. Verfahren nach Anspruch 1, **dadurch gekennzeichnet**, daß die Reaktionslösung nach dem Abtrennen des Polymers bzw. des Hydrohalogenids mittels eines Ionenaustauschers gereinigt wird.

3. Verfahren nach Anspruch 1 oder 2, **dadurch gekennzeichnet**, daß als Polymer ein Vinylpyridin-Polymer verwendet wird.

4. Verfahren nach Anspruch 3, **dadurch gekennzeichnet**, daß vernetztes Poly(4-vinylpyridin) verwendet wird.

5. Verfahren nach einem der Ansprüche 1 bis 4, **dadurch gekennzeichnet**, daß ein Dicarbonsäurechlorid verwendet wird.

6. Verfahren nach einem oder mehreren der Ansprüche 1 bis 5, **dadurch gekennzeichnet**, daß ein 2,2-Bis-(3-amino-4-hydroxyphenyl)-propan verwendet wird.

7. Verfahren nach einem oder mehreren der Ansprüche 1 bis 6, **dadurch gekennzeichnet**, daß als Lösemittel N-Methylpyrrolidon verwendet wird.

8. Verfahren zur Herstellung von Resistlösungen auf der Basis von alkalilöslichen Polybenzoxazol-Vorstufen nach einem oder mehreren der Ansprüche 1 bis 7, **dadurch gekennzeichnet**, daß die Reaktionslösung mit einer photoaktiven Komponente versetzt wird.

9. Verfahren nach Anspruch 8, **dadurch gekennzeichnet**, daß als photoaktive Komponente ein Chinondiazid verwendet wird.

## Claims

1. Process for the production of solutions of alkali-soluble polybenzoxazole precursors, characterised in that a dicarboxylic acid halide is reacted with a bis-(o-aminophenol) in an organic solvent in the presence of a polymer which is insoluble in the solvent and has a tertiary N atom, and that excess polymer and the hydrohalide thereof are separated from the reaction solution.

2. Process according to claim 1, characterised in that, once the polymer or the hydrohalide have been separated, the reaction solution is purified by means of an ion exchanger.

3. Process according to claim 1 or 2, characterised in that a vinylpyridine polymer is used as the polymer.

4. Process according to claim 3, characterised in that crosslinked poly(4-vinylpyridine) is used.

5. Process according to one of claims 1 to 4, characterised in that a dicarboxylic acid chloride is used.

6. Process according to one or more of claims 1 to 5, characterised in that a 2,2-his-(3-amino-4-hydroxyphenyl)propane is used.

7. Process according to one or more of claims 1 to 6, characterised in that N-methylpyrrolidone is used as the solvent.

8. Process for the production of resist solutions based on alkali-soluble polybenzoxazole precursors according to one or more of claims 1 to 7, characterised in that the reaction solution is combined with a photoactive component.

9. Process according to claim 8, characterised in that a quinone diazide is used as the photoactive component.

## Revendications

1. Procédé pour la préparation de solutions de précurseurs de polybenzoxazole solubles dans des alcalis, caractérisé en ce qu'on amène à réagir un halogénure d'acide dicarboxylique avec un bis-(o-aminophénol) dans un solvant organique en présence d'un polymère insoluble dans le solvant possédant un atome d'azote tertiaire et en ce qu'on sépare de la solution réactionnelle le polymère en excès et son hydrohalogénure.

2. Procédé selon la revendication 1, caractérisé en ce qu'on purifie la solution réactionnelle après la séparation du polymère, respectivement de l'hydrohalogénure, au moyen d'un échangeur d'ions.

3. Procédé selon la revendication 1 ou 2, caractérisé en ce qu'on utilise, comme polymère, un polymère de vinylpyridine.

4. Procédé selon la revendication 3, caractérisé en ce qu'on utilise de la poly(4-vinylpyridine) réticulée.

5. Procédé selon une des revendications 1 à 4, caractérisé en ce qu'on utilise un chlorure d'acide dicarboxylique.

6. Procédé selon une ou plusieurs des revendications 1 à 5, caractérisé en ce qu'on utilise un 2,2-bis-(3-amino-4-hydroxyphényl)propane.

7. Procédé selon une ou plusieurs des revendications 1 à 6, caractérisé en ce qu'on utilise comme solvant la N-méthylpyrrolidone.

8. Procédé pour la préparation de solutions de réserve à base de précurseurs de polybenzoxazole solubles dans des alcalis selon une ou plusieurs des revendications 1 à 7, caractérisé en ce qu'on ajoute, à la solution réactionnelle, un composant photo-actif.

9. Procédé selon la revendication 8, caractérisé en ce qu'on utilise, comme composant photo-actif, un diazide de quinone.
